# EUROPEAN PATENT APPLICATION

(11) **EP 4 844 526 A1**
(43) Date of publication of application: **25.11.2026**
(21) Application number: 26161576.9
(22) Date of filing: 02.03.2026
(51) Int. Cl.: G05F 3/24

(54) **SYSTEMS AND METHODS FOR IMPLEMENTING PSEUDO-RESISTORS WITH PROGRAMMABLE RESISTANCE AND CONTROLLED LEAKAGE**

(30) Priority: 10.03.2025 US 202519075265
(71) Applicant: Avago Technologies International Sales Pte. Limited, Singapore 768923 (SG)
(72) Inventor: Li, Shengyuan, Irvine, CA, 92602 (US); Guo, Jing, Irvine, CA, 92618 (US); Chandrasekhar, Vinay, Irvine, CA, 92602 (US); Jiang, Xicheng, Irvine, CA, 92612 (US); Kim, Min Gyu, Irvine, CA, 92618 (US)
(74) Representative: Grünecker Patent- und Rechtsanwälte PartG mbB

(57) **Abstract**

The subject technology is directed to electronic circuits. In an embodiment, the subject technology provides an apparatus that includes a resistor unit comprising a first transistor and a second transistor, where the first transistor includes a first terminal and the second transistor includes a second terminal. The resistor unit is configured to provide a first resistance between the first terminal and the second terminal. The apparatus further includes a first circuit coupled to the resistor unit and configured to adjust the first resistance by providing a bias voltage. A second circuit is coupled to the first circuit and configured to adjust the bias voltage by providing a bias current to the first circuit. By adjusting the bias voltage and bias current, the apparatus enables high-resistance, ultra-low-leakage, and tunable pseudo-resistor operation, improving stability and precision in low-power and high-impedance applications. There are other embodiments as well.

## Description

### FIELD OF INVENTION

The subject technology is directed to electronic circuits.

### BACKGROUND OF THE INVENTION

Resistors are important components in electronic systems, providing impedance control, voltage division, and signal conditioning in a wide range of applications. In many applications, such as analog front-end circuits of biosensing systems, low-power electronics, and precision instrumentation, extremely high resistance values-often in the gigaohm (GΩ) range or higher-are required to properly process weak signals and maintain high input impedance.

Achieving such high resistance in an integrated circuit (IC) environment presents significant challenges. Many approaches rely on passive resistor implementations, such as thin-film or polysilicon resistors, which often result in excessive silicon area consumption, making them impractical for high-density designs. Furthermore, variations in operating conditions, such as supply voltage, process parameters, and temperature fluctuations, can impact resistance stability, leading to inconsistent performance in high-precision applications.

In applications such as biosignal acquisition, sensor readout, and high-impedance analog circuits, maintaining predictable resistance characteristics is beneficial for ensuring accurate signal processing and minimizing distortion. Without precise control over resistance values, circuit performance may degrade, leading to reduced signal fidelity and compromised overall system reliability.

Various approaches for improving the stability, tunability, and leakage performance of resistor implementations have been explored, but they have proven to be insufficient. It is important to recognize the need for new and improved systems and methods.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a simplified diagram illustrating a pseudo-resistor system according to embodiments of the subject technology.
Figure 2 is a simplified diagram illustrating a resistor unit according to embodiments of the subject technology.
Figure 3 is a simplified diagram illustrating a first circuit of a pseudo-resistor system according to embodiments of the subject technology.
Figure 4 is a simplified diagram illustrating a second circuit of a pseudo-resistor system according to embodiments of the subject technology.

### DETAILED DESCRIPTION OF THE INVENTION

The subject technology is directed to electronic circuits. In an embodiment, the subject technology provides an apparatus that includes a resistor unit comprising a first transistor and a second transistor, where the first transistor includes a first terminal and the second transistor includes a second terminal, the first terminal being coupled to the second terminal. The resistor unit is configured to provide a first resistance between the first terminal and the second terminal. The apparatus further includes a first circuit coupled to the resistor unit and configured to adjust the first resistance by providing a bias voltage to the first transistor or the second transistor. A second circuit is coupled to the first circuit and configured to adjust the bias voltage by providing a bias current to the first circuit. The first transistor and the second transistor are disposed within an isolated well region, the isolated well region being coupled to the first circuit. By adjusting the bias voltage and bias current, the apparatus enables high-resistance, ultra-low-leakage, and tunable pseudo-resistor operation, improving stability and precision in low-power and high-impedance applications. There are other embodiments as well.

As previously noted, achieving extremely high resistance values in an IC environment presents significant challenges. To address these challenges, some approaches involve the use of pseudo-resistors. For example, the term "pseudo-resistors" may refer to resistive structures implemented using active devices instead of resistive materials. Pseudo-resistors may be implemented using metal-oxide-semiconductor field-effect transistors (MOSFETs) operating in weak inversion or subthreshold conduction, where the drain current is exponentially dependent on the gate-source voltage, resulting in extremely high resistance values. These structures have been developed as a compact alternative to achieve high resistance in ICs while reducing area consumption. Pseudo-resistors are widely used in low-power analog circuits, biomedical instrumentation amplifiers, and sensor readout circuits, where precise high-impedance characteristics are needed to process weak signals with minimal distortion.

However, achieving a stable and tunable resistance in pseudo-resistors remains challenging due to several factors, including process variations, bias voltage dependence, temperature sensitivity, and/or leakage currents. Many pseudo-resistor implementations often suffer from uncontrolled leakage currents, which can introduce signal distortion and degrade system performance, such as in biosignal acquisition, high-impedance front-end amplifiers, and other precision circuits requiring stable resistance values. Additionally, pseudo-resistor resistance is highly sensitive to variations in fabrication processes, operating voltages, and environmental temperature, leading to inconsistent performance across different conditions.

In various implementations, the subject technology provides systems and methods for implementing pseudo-resistors with improved stability, tunability, and leakage control. By integrating bias regulation techniques, feedback-controlled resistance tuning, and temperature-compensated biasing, the pseudo-resistor system according to various embodiments of the subject technology ensures stable resistance values across process, voltage, and temperature (PVT) variations. The system further incorporates deep-n-well (DNW) isolation and controlled biasing to minimize leakage currents and enhance linearity. Accordingly, the subject technology enables robust and efficient high-resistance implementations for applications requiring high-impedance characteristics, such as biosignal acquisition, precision analog front-end circuits, and/or sensor interfaces.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes an apparatus, which comprises a resistor unit comprising a first transistor and a second transistor. The first transistor comprises a first terminal, the second transistor comprises a second terminal. The first terminal is coupled to the second terminal, the resistor unit is configured to provide a first resistance between the first terminal and the second terminal. The apparatus further comprises a first circuit coupled to the resistor unit, the first circuit being configured to adjust the first resistance by providing a bias voltage to the first transistor or the second transistor. The apparatus further comprises a second circuit coupled to the first circuit, the second circuit being configured to adjust the bias voltage by providing a bias current to the first circuit. The first transistor is disposed within a first isolated well region, the first isolated well region is coupled to the first circuit

Implementations may include one or more of the following features. The first transistor comprises a third terminal coupled to the first circuit, the third terminal is configured to receive the bias voltage. The first transistor comprises a fourth terminal, the fourth terminal is electrically coupled to the first terminal. The first circuit comprises a voltage buffer coupled to the resistor unit, the voltage buffer is configured to stabilize the bias voltage. The first circuit comprises a third circuit characterized by a second resistance, the second resistance is associated with the first resistance. The third circuit comprises a third transistor, the first circuit is configured to adjust the first resistance by adjusting a size of the third transistor. The second circuit is configured to adjust the first resistance based on a logarithmic function of the bias current. The bias current comprises a constant current component. The bias current comprises a proportional-to-absolute-temperature (PTAT) current component.

According to another embodiment, the subject technology provides an apparatus that comprises a resistor unit comprising a first transistor and a second transistor. The first transistor comprises a first terminal and a first control terminal, the second transistor comprises a second terminal and a second control terminal. The first terminal is coupled to the second terminal, the resistor unit is configured to provide a first resistance between the first terminal and the second terminal. The apparatus further comprises a first circuit coupled to the resistor unit, the first circuit being configured to adjust the first resistance by providing a bias voltage to the first control terminal or the second control terminal. The apparatus further comprises a second circuit coupled to the first circuit, the second circuit being configured to adjust the bias voltage by providing a bias current to the first circuit. The first transistor is disposed within a first isolated well region, the second transistor is disposed within a second isolated well region, the first isolated well region and the second isolated well region are coupled to the first circuit.

Implementations may include one or more of the following features. The first circuit comprises a voltage buffer coupled to the first control terminal or the second control terminal. The first circuit comprises a third circuit characterized by a second resistance, the second resistance is associated with the first resistance. The second circuit is configured to adjust the first resistance based on a logarithmic function of the bias current. The bias current comprises a constant current component. The bias current comprises a proportional-to-absolute-temperature (PTAT) current component.

According to yet another embodiment, the subject technology provides an apparatus, which comprises a resistor unit comprising a first transistor and a second transistor. The first transistor comprises a first terminal, the second transistor comprises a second terminal. The first terminal is coupled to the second terminal, the resistor unit is configured to provide a first resistance between the first terminal and the second terminal. The apparatus further comprises a first circuit coupled to the resistor unit, the first circuit being configured to adjust the first resistance by providing a bias voltage to the first transistor or the second transistor. The apparatus further comprises a second circuit coupled to the first circuit, the second circuit being configured to adjust the bias voltage by providing a bias current to the first circuit, the bias current comprising a constant current component and a proportional-to-absolute-temperature (PTAT) current component. In various embodiments, the first transistor is disposed within an isolated well region, the isolated well region is coupled to the first circuit. The first transistor comprises a third terminal coupled to the first circuit, the third terminal is configured to receive the bias voltage. The first transistor comprises a fourth terminal, the fourth terminal is electrically coupled to the first terminal.

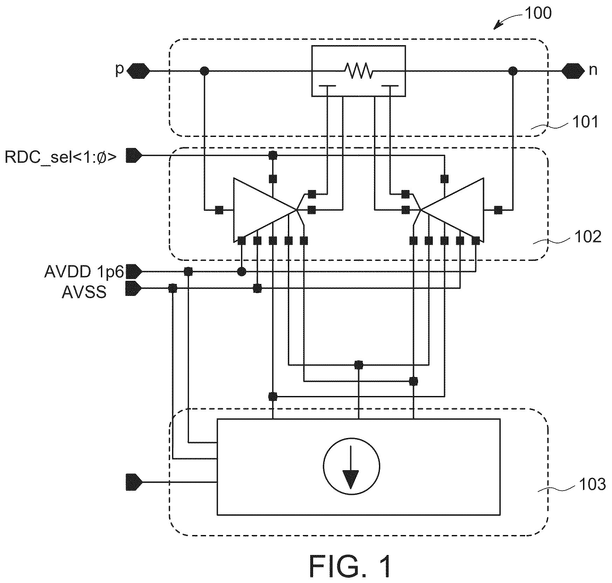

Figure 1 is a simplified diagram illustrating a pseudo-resistor system 100 according to embodiments of the subject technology. This diagram merely provides an example, which should not unduly limit the scope of the claims. One of ordinary skill in the art would recognize many variations, alternatives, and modifications. Pseudo-resistor system 100 may be implemented in various applications, including biosensing systems, low-power analog front-end (AFE) circuits, instrumentation amplifiers, sensor readout circuits, and/or other electronic systems requiring high-impedance characteristics. Depending on the application, pseudo-resistor system 100 may incorporate various features such as programmable resistance tuning, bias voltage control, temperature compensation, leakage current management, and/or the like.

As shown, system 100 includes at least one of resistor unit 101, first circuit 102, second circuit 103, and/or the like. These components work together to provide a tunable, high-resistance path while minimizing leakage and ensuring stable performance across varying conditions. For instance, system 100 is designed to achieve gigaohm (GΩ)-range resistance values and may be applied in bio-potential signal readout applications. Bio-potential signals-such as those measured in electrooculography (EOG), electroencephalography (EEG), electrocardiography (ECG), and/or electromyography (EMG)-operate at low voltage levels and within specific frequency ranges. These signals often exhibit low-frequency components spanning from sub-Hz to kilohertz (kHz) and are susceptible to electrode offset voltages generated at the skin-electrode interface. To accurately extract bio-potential signals, the readout front-end circuit may implement a high-pass filtering characteristic to reject unwanted DC offsets caused by electrode-skin interactions, necessitating an extremely high resistance when combined with an on-chip capacitor in the picofarad (pF) range.

In various implementations, resistor unit 101 is configured to provide a controllable high-resistance path between two terminals, such as an input terminal and an output terminal (e.g., p and n terminals). For example, the term "resistor unit" may refer to an electronic circuit or device that provides resistance to current flow. Depending on the application, the resistance value may be fixed, adjustable, programmable, or dynamically controlled. Resistor unit 101 may implemented using various circuit techniques, such as passive resistors, active transistor-based resistors, digitally programmable resistor arrays, and/or the like.

In some examples, resistor unit 101 may be implemented using transistors, which may include, without limitation, MOSFETs, bipolar junction transistors (BJTs), junction field-effect transistors (JFETs), and/or the like. In certain embodiments, resistor unit 101 may be referred to as a "pseudo-resistor unit," such as when implemented using transistor-based structures. The terms "resistor unit" and "pseudo-resistor unit" may be used interchangeably herein unless otherwise specified. As an example, resistor unit 101 may be implemented using MOS transistors operating in weak inversion or subthreshold conduction, allowing it to achieve extremely high resistance values in the gigaohm (GΩ) range or higher while occupying minimal silicon area.

In some embodiments, resistor unit 101 is configured to provide a programmable resistance value. This programmability may be achieved by applying a bias voltage to one or more terminals of the pseudo-resistor, effectively tuning the device's resistance characteristic. For instance, the bias voltage may be generated by an external control circuit (e.g., first circuit 102), enabling resistance adjustment to accommodate varying circuit conditions or signal processing requirements. Additionally, resistor unit 101 may be designed to support multiple resistance settings, allowing for discrete or continuous adjustments through selectable bias voltages or controlled bias current sources. In an example, resistor unit 101 may be configured with four selectable resistance settings (e.g., 30 GΩ, 40 GΩ, 50 GΩ, and 60 GΩ), enabling flexible programmability for varying application requirements. In certain configurations, resistor unit 101 may be designed to support a reset operation, allowing it to transition between normal and reset states in case of saturation or excessive charge accumulation.

In various implementations, first circuit 102 is configured to generate and regulate the bias voltage that is applied to resistor unit 101, enabling programmable resistance tuning and stable operation across varying conditions. For example, the term "bias voltage" may refer to a controlled voltage applied to a circuit element to establish a desired operating condition. The bias voltage generated by first circuit 102 determines the effective resistance of resistor unit 101 by controlling the operating point of the transistor-based pseudo-resistor structure. Depending on the implementation, first circuit 102 may generate the bias voltage based on external control signals, feedback regulation, predefined resistance settings, and/or other control mechanisms.

In some examples, the bias voltage may be applied to the deep-n-well (DNW) region of the transistor structure in resistor unit 101 to reduce leakage currents. By establishing a stable potential for the DNW, first circuit 102 helps suppress leakage paths that could otherwise degrade signal integrity. Additionally, the bias voltage is used to stabilize the gate potential of the pseudo-resistor transistors, ensuring that the resistance remains predictable across variations in PVT conditions. By compensating for these variations, first circuit 102 minimizes the effects of fabrication inconsistencies and environmental fluctuations, allowing resistor unit 101 to function reliably across different operating scenarios.

According to some embodiments, second circuit 103 is configured to generate and regulate a bias current that is applied to first circuit 102, enabling precise control of the bias voltage supplied to resistor unit 101. For example, the term "bias current" may refer to a controlled current used to establish or regulate the operating conditions of a circuit. The bias current plays an important role in determining the resistance characteristics of resistor unit 101, as it directly influences the voltage levels applied to the pseudo-resistor structure (e.g., resistor unit 101). By controlling the bias current, second circuit 103 ensures that the pseudo-resistor maintains a stable and tunable resistance while minimizing PVT variations. Depending on the implementation, the bias current may be generated from a constant current source, a proportional-to-absolute-temperature (PTAT) current source, or a combination of both.

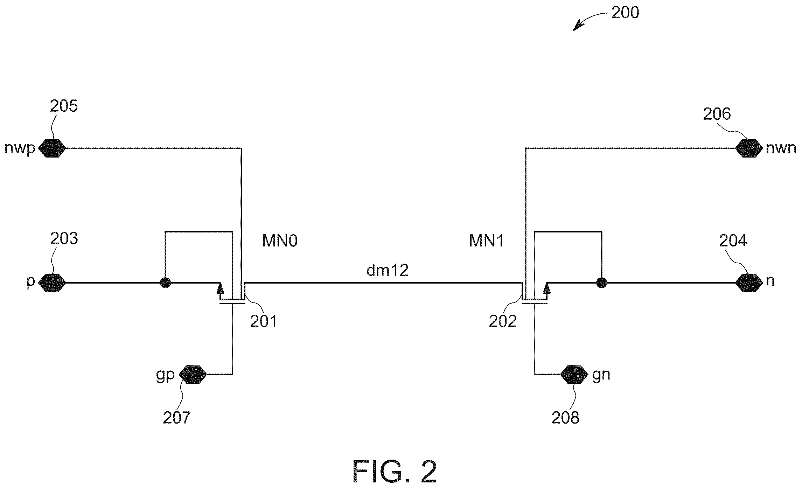

Figure 2 is a simplified diagram illustrating a resistor unit 200 according to embodiments of the subject technology. This diagram merely provides an example, which should not unduly limit the scope of the claims. One of ordinary skill in the art would recognize many variations, alternatives, and modifications. In some implementations, resistor unit 200 may be part of a pseudo-resistor system (e.g., system 100 of Figure 1). Resistor unit 200 may be configured to provide a high-resistance path between two circuit terminals-such as terminal 203 (e.g., p terminal) and terminal 204 (e.g., n terminal)-enabling the implementation of high-pass filtering, signal conditioning, and other impedance-sensitive operations.

In various embodiments, resistor unit 200 includes first transistor 201 (e.g., MN0) and second transistor 202 (e.g., MN1), which together form the pseudo-resistor structure. For example, the term "transistor" may refer to a semiconductor device used to control the flow of electrical current. Examples of transistors may include, without limitation, MOSFETs, BJTs, JFETs, and/or the like. For instance, first transistor 201 and second transistor 202 are implemented as negative-MOS (NMOS) transistors, operating in weak inversion or subthreshold conduction to achieve extremely high resistance values.

The resistance path may be formed between an input terminal (e.g., terminal 203) and an output terminal (e.g., terminal 204) through the conduction of first transistor 201 and second transistor 202. In various examples, first transistor 201 (e.g., MN0) includes a source terminal, a drain terminal, a gate terminal (e.g., gp), and a body terminal. The source and body terminals of first transistor 201 may be electrically coupled together. Similarly, second transistor 202 (e.g., MN1) includes a source terminal, a drain terminal, a gate terminal (e.g., gn), and a body terminal. The source and body terminals of second transistor 202 may be electrically coupled together. In other words, the body terminals of first transistor 201 and second transistor 202 may be shorted to their respective source terminals to reduce leakage and ensure predictable operation.

In some cases, the source terminals of first transistor 201 and second transistor 202 may be coupled to terminal 203 and terminal 204, respectively, forming the high-resistance path of the pseudo-resistor. The drain terminal of first transistor 201 may be coupled to the drain terminal of second transistor 202, forming a continuous path between terminals 203 and 204. This mirrored, symmetrical structure ensures that the pseudo-resistor exhibits consistent electrical characteristics, improving linearity and stability across a wide range of operating conditions. In other aspects, other arrangements such as cascaded or folded-cascade structures may be implemented.

According to various embodiments, gate terminal 207 (e.g., gp) of first transistor 201 and gate terminal 208 (e.g., gn) of second transistor 202 may be configured to receive bias voltages from an external circuit (e.g., first circuit 102 of Figure 1), which regulate the weak-inversion conduction characteristics of the transistors. The applied bias voltages control the extent to which current can flow between terminals 203 and 204, thereby defining the resistance of resistor unit 200.

As an example, resistor unit 200 may be configured to provide a first resistance between the drain terminals of first transistor 201 and second transistor 202. The resistance between the drain terminals may be determined by the biasing conditions applied to the gate terminals of the transistors (e.g., gp and gn), allowing for tunable resistance characteristics. In some implementations, the first resistance may be in the gigaohm (GΩ) range, enabling the pseudo-resistor to function effectively in high-impedance applications.

In some embodiments, first transistor 201 and second transistor 202 may be disposed within an isolated well region to further enhance leakage suppression and noise isolation. For example, the term "isolated well region" may refer to a semiconductor well structure that electrically isolates one or more transistors from the surrounding substrate. Examples of isolated well regions may include, without limitation, deep-n-well (DNW) structures, triple-well isolation regions, silicon-on-insulator (SOI) substrates, and/or the like. In some examples, first transistor 201 and second transistor 202 are each placed within separate deep-n-well (DNW) regions, such as DNW 205 (e.g., nwp) and DNW 206 (e.g., nwn), respectively. These DNW regions provide electrical isolation from the bulk substrate, reducing substrate noise coupling and unwanted leakage paths.

In various embodiments, a voltage buffer (not shown) may be used to bias the DNW at the same potential as the source terminal, effectively reducing body-to-DNW voltage differences. This minimizes leakage current at the input and output terminals (e.g., terminals 203 and 204) while preserving high resistance characteristics. In other examples, the voltage buffer may be omitted, and the DNW may be directly connected to a fixed high voltage, which is beneficial for reducing circuit complexity.

It is to be appreciated that the use of isolated DNWs in resistor unit 200 enables a controllable and stable high-resistance path, supporting programmable resistance values while mitigating unwanted parasitic effects. This approach enhances the feasibility of integrating high-resistance elements within standard CMOS processes without requiring an excessively large silicon area, making it well-suited for applications such as biosignal amplification, low-power analog circuits, high-impedance front-end circuits, and/or the like.

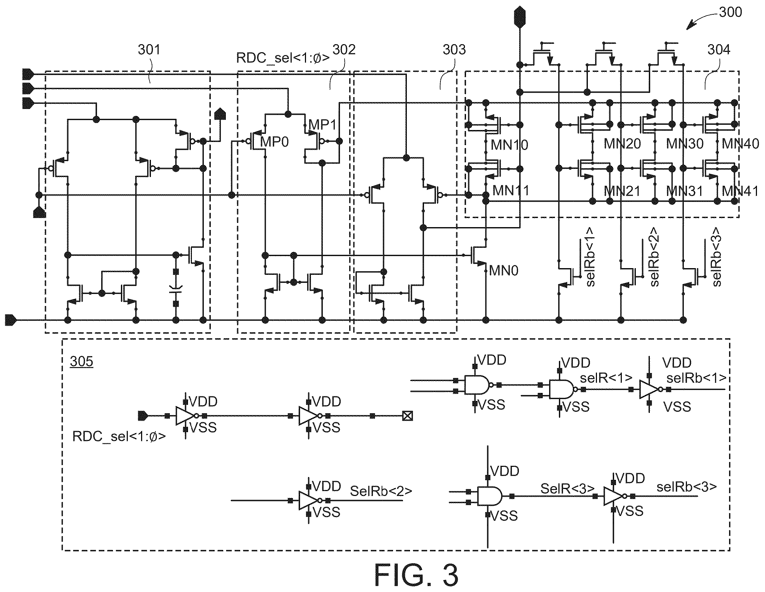

Figure 3 is a simplified diagram illustrating a first circuit 300 of a pseudo-resistor system according to embodiments of the subject technology. This diagram merely provides an example, which should not unduly limit the scope of the claims. One of ordinary skill in the art would recognize many variations, alternatives, and modifications.

In various implementations, first circuit 300 may be part of a pseudo-resistor system (e.g., system 100 of Figure 1) and may be configured to generate and regulate bias voltages and/or currents applied to a pseudo-resistor unit (e.g., resistor unit 200 of Figure 2). First circuit 300 ensures proper operation of the pseudo-resistor by providing stable and programmable bias conditions, enabling tunable resistance values while maintaining low leakage and high linearity. For instance, first circuit 300 may be configured to generate a bias voltage that regulates the operating conditions of resistor unit 200. The bias voltage generated by first circuit 300 may be used to control the gate potential of the transistors in resistor unit 200, ensuring that the device operates within a predictable resistance range.

As shown, first circuit 300 may include at least one of voltage buffer 301, bias voltage generator 302, amplifier 303, replica bias circuit 304, and/or the like. These components work together to generate and regulate bias voltages and/or currents, ensuring the pseudo-resistor unit operates with stable resistance characteristics across varying process, voltage, and temperature conditions.

In some examples, voltage buffer 301 may be coupled to a pseudo-resistor unit (e.g., resistor unit 200 of Figure 2) and configured to stabilize the DNW potential of the transistors within the pseudo-resistor structure. For instance, an input of voltage buffer 301 may be coupled to the input or output terminal of resistor unit 200 (e.g., terminal 203 or 204). An output of voltage buffer 301 may be coupled to the DNW of first transistor 201 (e.g., nwp) or the DNW of second transistor 202 (e.g., nwn). By buffering the voltage applied to the DNW, voltage buffer 301 ensures that the DNW potential remains close to the respective source terminal potential of the transistor, thereby minimizing leakage currents and preserving the high-resistance characteristics of the resistor unit.

In various implementations, bias voltage generator 302 may be coupled to voltage buffer 301. For example, the term "bias voltage generator" may refer to a circuit that produces a stable voltage to establish a desired operating point for a device. In some cases, bias voltage generator 302 may be configured to generate a reference bias voltage (e.g., ΔV_{BE}) and a reference bias current, which together establish a stable reference potential for the pseudo-resistor. As an example, bias voltage generator 302 includes transistors MP0 and MP1, which are configured to generate the reference bias voltage (e.g., ΔV_{BE}). Bias voltage generator 302 may further include transistor MN0, which is configured to generate the reference bias current.

In some embodiments, amplifier 303 may be coupled to bias voltage generator 302 and configured to regulate and condition the reference bias voltage and bias current before it is applied to replica bias circuit 304. For example, the term "amplifier" may refer to a circuit that increases the magnitude of an input signal while preserving its characteristics. Examples of amplifiers may include, without limitation, operational amplifiers (op-amps), single-stage amplifiers, differential amplifiers, and/or the like. Amplifier 303 regulates the biasing of the replica bias transistors in replica bias circuit 304 to ensure consistent and accurate bias voltage application. The regulated output of amplifier 303 helps to maintain the desired voltage level at the gate terminals of the transistors, helping to stabilize the resistance of the pseudo-resistor unit.

In various implementations, replica bias circuit 304 may be coupled to amplifier 303. For example, the term "replica bias circuit" may refer to a circuit that mimics or replicates the behavior of another circuit element to provide a stable reference for biasing and tuning. In some examples, replica bias circuit 304 includes one or more replica transistors (e.g., MN10, MN11, MN20, MN21, MN30, MN31, MN40, and MN41), which are configured to operate under conditions that mirror those of the pseudo-resistor transistors in resistor unit 200. These replica transistors may be arranged in a programmable configuration, allowing for discrete or continuous resistance adjustments.

In certain embodiments, the reference bias voltage and bias current supplied to replica bias circuit 304 are regulated by amplifier 303 to ensure that the replica transistors receive stable operating conditions. The regulated bias voltage is applied to the gate terminals of the replica transistors, establishing a controlled conduction state that mimics the behavior of the transistors in resistor unit 200. For instance, replica bias circuit 304 may be characterized by a second resistance, which is associated with the first resistance

In some examples, replica bias circuit 304 operates based on a feedback loop that regulates the gate voltage of the replica transistors to maintain a predetermined operating condition. For instance, the feedback loop ensures that a known current (e.g., the reference bias current) flows through the replica transistors, thereby generating a well-defined voltage. This regulation mechanism stabilizes the pseudo-resistor's resistance characteristics, mitigating variations due to PVT fluctuations.

In various implementations, the effective resistance of resistor unit 200 (e.g., the first resistance) may be determined by the biasing conditions applied to replica bias circuit 304, which serves as a reference for defining the operating characteristics of the pseudo-resistor transistors. For instance, one or more replica transistors (e.g., MN10, MN11, MN20, MN21, MN30, MN31, MN40, and MN41) may be selectively activated or deactivated to control the overall gate bias voltage of the pseudo-resistor.

In some examples, the effective resistance of resistor unit 200 (e.g., the first resistance) may be linearly tuned or configured by scaling the total active transistor size in replica bias circuit 304. In other words, increasing the total width of the replica transistors results in a proportional decrease in resistance. First circuit 300 may be configured to adjust the first resistance by adjusting a size of the replica transistors. By adjusting the size and activation of the transistors in replica bias circuit 304, the system can achieve precise control over the resistance of the pseudo-resistor unit. The programmable nature of replica bias circuit 304 may allow for adjustment of the pseudo-resistor's resistance, which may be achieved by selecting from the multiple replica transistors of different sizes based on the desired resistance setting. In other aspects, the resistance may exhibit a logarithmic dependence on the bias current, allowing for an extended range of resistance tuning.

In certain embodiments, first circuit 300 may further include control circuit 305 to further enhance the configurability of replica bias circuit 304 by providing a digital selection mechanism for different resistance settings. For instance, a 2-bit programmability scheme (e.g., RDC_sel<1:0>) allows the selection of multiple resistance values by controlling different transistor groups within replica bias circuit 304. In some examples, replica bias circuit 304 may include one or more groups of transistors, such as MN10 and MN11, MN20 and MN21, MN30 and MN31, and MN40 and MN41. By selectively enabling different transistor groups based on the RDC_sel<1:0> control bits, one or more discrete resistance settings (e.g., 30 GΩ, 40 GΩ, 50 GΩ, and 60 GΩ) may be achieved.

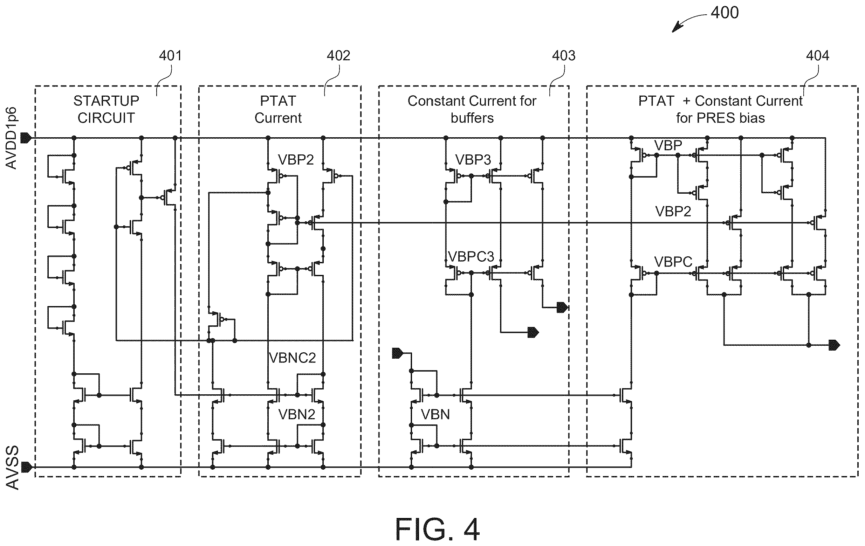

Figure 4 is a simplified diagram illustrating a second circuit 400 of a pseudo-resistor system according to embodiments of the subject technology. This diagram merely provides an example, which should not unduly limit the scope of the claims. One of ordinary skill in the art would recognize many variations, alternatives, and modifications.

In various implementations, second circuit 400 may be part of a pseudo-resistor system (e.g., system 100 of Figure 1) and may be configured to generate and distribute bias currents that are applied to various components of the system, including a pseudo-resistor unit (e.g., resistor unit 200 of Figure 2) and/or a first circuit (e.g., first circuit 300 of Figure 3). In some examples, the bias current generated by second circuit 400 regulates the behavior of voltage buffers, replica bias circuits, and other bias-dependent components, helping to maintain the predictable operation of the pseudo-resistor system.

As shown, second circuit 400 includes at least one of startup circuit 401, PTAT current generation circuit 402, constant current generation circuit 403, bias current generation circuit 404, and/or the like. These components collectively generate bias currents in the nanoampere (nA) or sub-nA range, ensuring the stable operation of the pseudo-resistor system. In some examples, second circuit 400 is implemented as a current reference circuit that supplies multiple independent bias currents to different components of the pseudo-resistor system.

According to some embodiments, startup circuit 401 may be configured to initialize the operation of PTAT current generation circuit 402. For example, the term "startup circuit" may refer to a circuit configured to establish a defined operating state upon power-up. In certain implementations, startup circuit 401 prevents PTAT current generation circuit 402 from remaining in an unintended zero-current state by enforcing a small initial current until normal operation is established. Once PTAT current generation circuit 402 reaches a stable operating point, startup circuit 401 disengages, allowing normal operation to proceed.

In various embodiments, PTAT current generation circuit 402 may be coupled to startup circuit 401 and configured to generate a proportional-to-absolute-temperature (PTAT) current. For example, the term "proportional-to-absolute-temperature current" may refer to a current that varies proportionally with absolute temperature and may be used in analog biasing circuits to compensate for temperature-induced variations.

In some examples, PTAT current generation circuit 402 may utilize a bandgap voltage reference or a BJT-based circuit to generate the PTAT current, which may be used in subsequent circuit blocks to compensate for variations in temperature that may otherwise affect resistance stability in the pseudo-resistor system. In some cases, PTAT current generation circuit 402 may utilize a current mirror arrangement to generate temperature-dependent reference currents for the system. Depending on the implementation, other temperature compensation techniques may be employed. For example, a complementary-to-absolute-temperature (CTAT) current source may be utilized in conjunction with the PTAT source to achieve improved temperature stability.

In some implementations, constant current generation circuit 403 may be configured to generate a constant current. For example, the term "constant current" may refer to a current that remains relatively stable regardless of variations in temperature, process, or supply voltage. In some cases, constant current generation circuit 403 may derive its current from a central bias core and distribute it to various circuit components within the pseudo-resistor system. For instance, the constant current generated by constant current generation circuit 403 may be used to bias voltage buffers (e.g., voltage buffer 301 of Figure 3) and/or other components within the pseudo-resistor system, providing a stable operating current to maintain predictable behavior.

In various implementations, bias current generation circuit 404 may be coupled to PTAT current generation circuit 402 and/or constant current generation circuit 403. For example, the term "bias current generation circuit" may refer to a circuit configured to generate and distribute a current that establishes a stable operating point for other circuit elements. Bias current generation circuit 404 may provide a tunable current source that ensures precise control over the operating conditions of the pseudo-resistor system. Depending on the implementation, the bias current generated by bias current generation circuit 404 may include a combination of constant current and PTAT current components to optimize circuit performance across varying environmental conditions. In some embodiments, bias current generation circuit 404 is configured to supply the bias current to a replica bias circuit (e.g., replica bias circuit 304 of Figure 3) to enable precise tuning of the pseudo-resistor's resistance. In some examples, second circuit 400 may be configured to adjust the first resistance based on a logarithmic function of the bias current.

The various circuit blocks within the pseudo-resistor system may be interconnected through multiple nodes and signal paths. In some cases, power supply connections and ground references may be distributed throughout the system to ensure the proper operation of each block.

While the above is a full description of the specific embodiments, various modifications, alternative constructions and equivalents may be used. Therefore, the above description and illustrations should not be taken as limiting the scope of the subject technology which is defined by the appended claims.

## Claims

1. An apparatus comprising:
a resistor unit comprising a first transistor and a second transistor, the first transistor comprising a first terminal, the second transistor comprising a second terminal, the first terminal being coupled to the second terminal, the resistor unit being configured to provide a first resistance between the first terminal and the second terminal;
a first circuit coupled to the resistor unit, the first circuit being configured to adjust the first resistance by providing a bias voltage to the first transistor or the second transistor; and
a second circuit coupled to the first circuit, the second circuit being configured to adjust the bias voltage by providing a bias current to the first circuit;
wherein the first transistor is disposed within a first isolated well region, the first isolated well region is coupled to the first circuit.

2. The apparatus of claim 1, wherein the first transistor comprises a third terminal coupled to the first circuit, the third terminal is configured to receive the bias voltage.

3. The apparatus of claim 1 or 2, wherein the first transistor comprises a fourth terminal, the fourth terminal is electrically coupled to the first terminal.

4. The apparatus of any preceding claim, wherein the first circuit comprises a voltage buffer coupled to the resistor unit, the voltage buffer is configured to stabilize the bias voltage.

5. The apparatus of any preceding claim, wherein the first circuit comprises a third circuit **characterized by** a second resistance, the second resistance is associated with the first resistance,
in particular, wherein the third circuit comprises a third transistor, the first circuit is configured to adjust the first resistance by adjusting a size of the third transistor.

6. An apparatus comprising:
a resistor unit comprising a first transistor and a second transistor, the first transistor comprising a first terminal and a first control terminal, the second transistor comprising a second terminal and a second control terminal, the first terminal being coupled to the second terminal, the resistor unit being configured to provide a first resistance between the first terminal and the second terminal;
a first circuit coupled to the resistor unit, the first circuit being configured to adjust the first resistance by providing a bias voltage to the first control terminal or the second control terminal; and
a second circuit coupled to the first circuit, the second circuit being configured to adjust the bias voltage by providing a bias current to the first circuit;
wherein the first transistor is disposed within a first isolated well region, the second transistor is disposed within a second isolated well region, the first isolated well region and the second isolated well region are coupled to the first circuit.

7. The apparatus of claim 6, wherein the first circuit comprises a voltage buffer coupled to the first control terminal or the second control terminal.

8. The apparatus of claim 6 or 7, wherein the first circuit comprises a third circuit **characterized by** a second resistance, the second resistance is associated with the first resistance.

9. The apparatus of any preceding claim, wherein the second circuit is configured to adjust the first resistance based on a logarithmic function of the bias current.

10. The apparatus of any preceding claim, wherein the bias current comprises a constant current component.

11. The apparatus of any preceding claim, wherein the bias current comprises a proportional-to-absolute-temperature (PTAT) current component.

12. An apparatus comprising:
a resistor unit comprising a first transistor and a second transistor, the first transistor comprising a first terminal, the second transistor comprising a second terminal, the first terminal being coupled to the second terminal, the resistor unit being configured to provide a first resistance between the first terminal and the second terminal;
a first circuit coupled to the resistor unit, the first circuit being configured to adjust the first resistance by providing a bias voltage to the first transistor or the second transistor; and
a second circuit coupled to the first circuit, the second circuit being configured to adjust the bias voltage by providing a bias current to the first circuit, the bias current comprising a constant current component and a proportional-to-absolute-temperature (PTAT) current component.

13. The apparatus of claim 12, wherein the first transistor is disposed within an isolated well region, the isolated well region is coupled to the first circuit.

14. The apparatus of claim 12 or 13, wherein the first transistor comprises a third terminal coupled to the first circuit, the third terminal is configured to receive the bias voltage, and/or
wherein the first transistor comprises a fourth terminal, the fourth terminal is electrically coupled to the first terminal.

15. The apparatus of any of claims 12 to 14, wherein the second circuit is configured to adjust the first resistance based on a logarithmic function of the bias current.
